# EUROPÄISCHE PATENTANMELDUNG

(11) **EP 2 530 744 A2**
(43) Veröffentlichungstag der Anmeldung: **05.12.2012**
(21) Anmeldenummer: 12170143.7
(22) Anmeldetag: 31.05.2012
(51) Int. Cl.: H01L 31/052

(54) **Solareinrichtung mit Reflektorvorrichtung**

(30) Priorität: 01.06.2011 DE 102011103170
(71) Anmelder: Erz, David, 89150 Laichingen (DE)
(72) Erfinder: Erz, David, 89150 Laichingen (DE)
(74) Vertreter: Cullinane, Marietta Bettina

(57) **Zusammenfassung**

Die vorliegende Erfindung betrifft eine Solareinrichtung, die mindestens eine Solaranlage (10) mit mindestens einer Gruppe von Solarpaneelen (101) und mindestens eine Reflektorvorrichtung (11) aufweist. Die Solareinrichtung (1) ist dadurch gekennzeichnet, dass die mindestens eine Reflektorvorrichtung (11) zu der mindestens einen Gruppe (102) der Solarpaneele (101) beabstandet angeordnet ist und bezüglich dieser Gruppe (102) der Solarpaneele (101) ausrichtbar ist. Weiterhin betrifft die vorliegende Erfindung eine Reflektorvorrichtung (11) für eine Solareinrichtung (1) mit mindestens einer Solaranlage (10) mit mindestens zwei Solarpaneelen (101), wobei die Reflektorvorrichtung (11) eine Haltevorrichtung (115) und mindestens einen Reflektor (111, 112, 113, 114) umfasst. Die Reflektoreinrichtung (1) ist dadurch gekennzeichnet, dass der mindestens eine Reflektor (111, 112, 113, 114) an der Haltevorrichtung (115) schwenkbar befestigt ist.

## Beschreibung

Die vorliegende Erfindung betrifft eine Solareinrichtung mit mindestens einer Reflektorvorrichtung sowie eine Reflektorvorrichtung mit mindestens einem Reflektor für eine Solareinrichtung. Die Reflektorvorrichtung dient insbesondere zur Erhöhung des Wirkungsgrades der Solareinrichtung.

Die Verwendung von Solareinrichtungen zur umweltfreundlichen Gewinnung von Wärme und Energie nimmt mehr und mehr an wirtschaftlicher Bedeutung zu. Um den unterschiedlichen Sonneneinstrahlwinkeln, die tageszeit- und jahreszeitbedingt sind, Rechnung tragen zu können, ist es bekannt die Absorber oder Solarmodule von Solareinrichtungen beweglich zu montieren. Hierdurch können die Absorber oder Solarmodule dem Sonnenstand nachgeführt werden. Ein Nachteil dieser Art der Erhöhung des Wirkungsgrades besteht darin, dass insbesondere bei großen Solareinrichtungen, die beispielsweise Felder von Solarpaneelen, umfassen können, dass der Energiebedarf und der Steuerungsaufwand für eine gezielte Nachführung der Paneele groß ist und der Aufbau und die Instandhaltung der Solareinrichtung somit aufwändig sind.

Weiterhin sind Solareinrichtungen bekannt, bei denen an jedem Paneel ein eine Reflektorvorrichtung befestigt ist. Diese kann beispielsweise ein Spiegel oder ein Tuch sein. Auch bei diesen Einrichtungen besteht der Nachteil in dem komplexen Aufbau und der damit verbundenen aufwändigen Instandhaltung. Zudem kommt es insbesondere bei Solareinrichtungen, bei denen mehrere Paneele nebeneinander angeordnet sind, zu einer Schattenbildung auf benachbarten Paneelen durch die Reflektorvorrichtung.

Der vorliegenden Erfindung liegt damit die Aufgabe zugrunde eine Solareinrichtung und eine Reflektorvorrichtung zu schaffen, bei denen die Nachteile des Standes der Technik behoben oder zumindest verringert werden.

Der Erfindung liegt die Erkenntnis zugrunde, dass diese Aufgabe gelöst werden kann, indem ein Reflektor mehreren Paneelen zugeordnet werden kann.

Gemäß einem ersten Aspekt wird die Aufgabe daher gelöst durch eine Solareinrichtung, die mindestens eine Solaranlage mit mindestens einer Gruppe von Solarpaneelen, die im Folgenden auch als Feld bezeichnet wird, und mindestens eine Reflektorvorrichtung aufweist. Die Solareinrichtung ist dadurch gekennzeichnet, dass die mindestens eine Reflektorvorrichtung zu der mindestens einen Gruppe der Solarpaneele beabstandet angeordnet ist und bezüglich dieser Gruppe der Solarpaneele ausrichtbar ist.

Die Solareinrichtung kann außer der Solaranlage und der Reflektorvorrichtung weitere Komponenten, wie Steuerungen und dergleichen aufweisen. Als Solaranlage wird im Sinne der Erfindung eine Anlage, die zur Umwandlung von Sonnenenergie in eine andere Energieform dient, bezeichnet. Insbesondere kann die Solaranlage eine thermische Solaranlage oder eine Photovoltaikanlage sein. Im Fall einer thermischen Solaranlage stellen die Paneele der Solaranlage Kollektorpaneele oder Absorberpaneele dar, die im Folgenden auch als Kollektoren oder Absorber bezeichnet werden. Bei einer Photovoltaikanlage stellen die Paneele Solarmodule dar, die jeweils mehrere Solarzellen aufweisen können. Die Paneele können auf oder an Gebäuden oder auf dem Boden befestigt sein. Die Gruppen von Solarpaneelen, die in der Solaranlage vorhanden sind, umfassen vorzugsweise mehr als zwei Paneele. Die Gruppen werden im Folgenden auch als Felder bezeichnet. Jede Gruppe stellt in der Solaranlage eine Einheit dar, die beispielsweise zur Weiterleitung der gewonnenen Energie zusammengefasst ist. Die Paneele der Gruppe können zu der Fläche, an der oder auf der diese befestigt sind, parallel oder geneigt angeordnet sein. Bei auf dem Boden befestigten Paneelen können diese beispielsweise aus der Horizontalen geneigt angeordnet sein.

Als Reflektorvorrichtung wird im Sinne der vorliegenden Erfindung eine Vorrichtung bezeichnet, die zumindest einen Reflektor mit mindestens einer Reflexionsfläche umfasst. Zudem kann die Reflektorvorrichtung Vorrichtungen zum Bewegen des oder der Reflektoren aufweisen. Vorzugsweise sind bei der erfindungsgemäßen Solareinrichtung mehrere Reflektorvorrichtungen vorgesehen, wobei jeder Gruppe von Paneellen eine oder mehrere Reflektorvorrichtungen zugeordnet sind, das heißt Licht auf diese Gruppe reflektieren. Die Anzahl der Reflektorvorrichtungen ist aber auch bei einer Ausführungsform mit mehreren Reflektorvorrichtungen pro Gruppe der Paneele in jedem Fall geringer als die Anzahl der Paneele pro Gruppe. Gemäß einer Ausführungsform kann die Anzahl der Reflektorvorrichtungen auch geringer sein als die Anzahl der Gruppen der Solaranlage. In diesem Fall versorgt eine Reflektorvorrichtung mehrere Gruppen von Paneelen mit Licht.

Als zu der Gruppe der Paneele beabstandet angeordnet wird eine Reflektorvorrichtung bezeichnet, bei der in senkrechter Projektion auf die Gruppe der Paneele der Reflektor der Reflektorvorrichtung in einem Abstand zu dem äußeren Rand der Gruppe angeordnet ist. Der Abstand hängt von der Größe und der Höhe des Reflektors, der Größe der zugeordneten Gruppe sowie der Anzahl der Reflektoren in der Gruppe ab und kann beispielsweise mindestens 0,5 m betragen. Nach oben ist die Größe des Abstandes nicht beschränkt.

Weiterhin wird als zu der Gruppe der Paneele beabstandet angeordnet eine Reflektorvorrichtung verstanden, die oberhalb der Gruppe der Paneele, insbesondere in einem Abstand zu der höchsten Stelle der Gruppe der Paneele angeordnet ist. Insbesondere, ist die Reflektorvorrichtung nicht an der Gruppe der Paneele oder an einem einzelnen Paneel befestigt. Die Reflektorvorrichtung ist erfindungsgemäß zu der Gruppe von Paneelen beabstandet, die der Reflektorvorrichtung zugeordnet ist, das heißt, die durch diese Reflektorvorrichtung mit reflektierten Lichtstrahlen versorgt werden soll.

Weiterhin ist die Reflektorvorrichtung bezüglich der Gruppe der Paneele ausrichtbar. Die Ausrichtbarkeit wird vorzugsweise erzielt, indem der Reflektor oder die Reflektoren der Reflektorvorrichtung beweglich befestigt sind, vorzugsweise an einer Haltevorrichtung der Reflektorvorrichtung. Die Bewegung der Reflektoren bezüglich der Haltevorrichtung stellt vorzugsweise ein Verschwenken und/oder ein Verschieben dar.

Alternativ oder zusätzlich kann auch die gesamte Reflektorvorrichtung bewegt werden, um eine Ausrichtung des Reflektors oder der Reflektoren gegenüber der Gruppe von Paneelen zu erreichen. Hierzu kann beispielsweise die Haltevorrichtung der Reflektorvorrichtung mit Rollen versehen sein, die ein Verändern der relativen Position der Reflektorvorrichtung zu der Gruppe der Paneele erlaubt.

Indem die Reflektorvorrichtung zu der Gruppe der Paneele beabstandet angeordnet ist, kann auch bei einer geringen Größe des Reflektors der Reflektorvorrichtung ein großer Bereich der Gruppe der Paneele, vorzugsweise zumindest eine gesamte Gruppe der Paneele, von den vom Reflektor reflektieren Lichtstrahlen erfasst werden. Somit ist es bei der erfindungsgemäßen Solareinrichtung nicht erforderlich die einzelnen Paneele mit Reflektorvorrichtungen zu versehen, wodurch sich der Aufbau der Solareinrichtung und insbesondere der Solaranlage vereinfacht. Zudem kann durch den Abstand zu der Gruppe der Paneele auch ein Abschirmen einzelner Paneele durch die Reflektorvorrichtung verhindert werden, was bei einer Anbringung eines Reflektors an jeder der Paneele nicht möglich ist.

Die Größe der Reflektoren, der Gruppe der Paneele und der Abstand zwischen dem oder den Reflektoren und der Gruppe von Paneelen sind erfindungsgemäß nicht auf bestimmte Beträge beschränkt. Diese Größen werden in Abhängigkeit der Anzahl, Abmessungen und Anordnung der einzelnen Komponenten der Solareinrichtung gewählt.

Indem zusätzlich die Reflektorvorrichtung bezüglich der Gruppe der Paneele, zu der diese beabstandet ist, ausrichtbar ist, können die von dem Reflektor reflektierten Lichtstrahlen gezielt auf Bereiche der Gruppe oder die gesamte Gruppe gerichtet werden. Durch die Ausrichtbarkeit der Reflektorvorrichtung kann insbesondere dem unterschiedlichen Sonnenstand zu unterschiedlichen Tages- oder Jahreszeiten Rechnung getragen werden. Somit ist ein Verschwenken der einzelnen Paneele der Solaranlage, wie dies im Stand der Technik beschrieben ist, nicht erforderlich und der Aufbau der Solaranlage wird weiter vereinfacht.

Gemäß einer Ausführungsform ist die mindestens eine Reflektorvorrichtung im montierten Zustand westlich, nördlich, östlich oder südlich zu der Gruppe der Paneele angeordnet. Während eine nördlich zu der Gruppe von Paneelen angeordnete Reflektorvorrichtung beispielsweise bei horizontal montierten Paneelen von Vorteil ist, können beispielsweise westlich, südlich oder nördlich angeordnete Reflektorvorrichtungen auch bei geneigt angeordneten Paneelen den Wirkungsgrad der Solaranlage verbessern. Bei beweglich angeordneten Paneelen einer Gruppe von Paneelen, kann die Ausrichtung der Reflektorvorrichtung zu der Gruppe entsprechend angepasst werden. Zu diesem Zweck kann die Reflektorvorrichtung selber ebenfalls beweglich angeordnet sein.

Gemäß einer bevorzugten Ausführungsform weist die mindestens eine Reflektorvorrichtung solche Abmessungen auf und ist so angeordnet, dass die von der Reflektorvorrichtung auf die Solaranlage reflektierten Lichtstrahlen zumindest auf zwei Solarpaneele der Solaranlage auftreffen. Die Abmessungen der Reflektorvorrichtung, die zu einer solchen Lichtstrahlung führen, sind zum einen die Größe und Form des Reflektors und insbesondere der Reflexionsfläche des Reflektors abhängig. Weiterhin ist auch die Höhe einer gegebenenfalls vorgesehenen Haltevorrichtung der Reflektorvorrichtung maßgeblich für den Verlauf der reflektierten Strahlen. Vorzugsweise ist die Reflektorvorrichtung so angeordnet, dass der oder die Reflektoren auf einer Höhe liegen, die höher als die Höhe des höchsten Punktes der Solaranlage ist. Allerdings kann, beispielsweise bei Paneelen der Solaranlage, die geneigt angeordnet sind oder die beweglich sind und somit in eine geneigte Stellung gebracht werden können, der Reflektor oder die Reflektoren auch in einer Höhe vorgesehen sein, die niedriger ist als der höchste Punkt der Paneele. In diesem Fall ist die Ausrichtung des Reflektors oder der Reflektoren so angepasst, dass die von diesen reflektierte Strahlung auf die Paneelen gerichtet ist.

Gemäß einem weiteren Aspekt betrifft die Erfindung eine Reflektorvorrichtung für eine Solareinrichtung mit mindestens einer Solaranlage mit mindestens zwei Solarpaneelen, wobei die Reflektorvorrichtung eine Haltevorrichtung und mindestens einen Reflektor umfasst. Die Reflektorvorrichtung ist dadurch gekennzeichnet, dass der mindestens eine Reflektor an der Haltevorrichtung schwenkbar befestigt ist.

Die Haltevorrichtung der Reflektorvorrichtung kann beispielsweise ein Pfosten, ein Mast oder ein längliches Gerüst sein. Vorzugsweise ist der mindestens eine Reflektor um eine Achse schwenkbar, die in der Vertikalen oder der Horizontalen liegt. Damit kann der mindestens eine Reflektor aus einer vertikalen Ausgangsstellung sowohl zu den Seiten als auch nach oben und nach unten verschwenkt werden. Die Verschwenkbarkeit des oder der Reflektoren wird vorzugsweise durch ein oder mehrere Gelenke realisiert, über die der Reflektor oder die Reflektoren mit der Haltevorrichtung verbunden sind.

Zusätzlich zu der Verschwenkbarkeit kann der Reflektor oder können die Reflektoren auch so an der Haltevorrichtung befestigt sein, dass translatorische Bewegungen ausgeführt werden können. So kann der Reflektor oder können die Reflektoren beispielsweise in vertikaler Richtung verschiebbar an der Haltevorrichtung befestigt sein.

Indem der mindestens eine Reflektor schwenkbar mit der Haltevorrichtung verbunden ist, wird eine gezielte Ausrichtung des mindestens einen Reflektors bezüglich einer beabstandten Gruppe von Solarpaneelen ermöglicht.

Gemäß einer Ausführungsform weist die Reflektorvorrichtung mindestens zwei Reflektoren auf und die mindestens zwei Reflektoren können unabhängig voneinander bewegt werden. Durch diese Ausführungsform wird es möglich einzelne Reflektoren auf unterschiedliche Bereiche einer Gruppe eines Solarpaneels zu richten und damit eine gleichmäßige Versorgung der Paneele der Gruppe mit reflektierten Lichtstahlen zu ermöglichen. Dennoch ist der Aufbau der Solareinrichtung einfach, da für die Reflektoren lediglich eine einzige Haltevorrichtung vorgesehen werden muss. Zudem ist eine solche Ausführungsform auch von Vorteil, da dadurch die Gefahr des Abschirmens von benachbarten Gruppen von Solarpaneelen minimiert wird, da die mehreren Reflektoren an einer Stelle vorgesehen sind.

Gemäß einer Ausführungsform weist mindestens einer der Reflektoren eine streuende Reflexionsfläche auf. Die streuende Wirkung der Reflexionsfläche kann durch die Form des Reflektors und/oder durch die Oberflächenbeschaffenheit der Reflexionsfläche erzielt werden. So wird beispielsweise die Reflexionsfläche so ausgebildet, dass an dieser eine diffuse Reflexion erfolgt. Hierzu wird die Reflexionsfläche beispielsweise mit prismenförmigen Prägungen versehen. Zusätzlich oder alternativ kann die Reflexionsfläche eine konvexe Form aufweisen, durch die auf die Reflexionsfläche auftreffende Lichtstrahlen gestreut werden.

Alternativ kann der Reflektor aber auch eine bündelnde Reflexionsfläche aufweisen. Auch die bündelnde Wirkung kann durch die Form der Reflexionsfläche und/oder durch die Oberflächenbeschaffenheit der Reflexionsfläche bewirkt oder verstärkt werden. Die Reflexionsfläche weist bei dieser Ausführungsform beispielsweise eine konkave Form auf. Die Verwendung eines bündelnden Reflektors für die Reflektorvorrichtung ist erfindungsgemäß möglich, da die Reflektorvorrichtung zu der Solaranlage, insbesondere zu dem Solarpaneel, beabstandet ist und daher ein zu starkes Konzentrieren der reflektierten Strahlen auf eines der Paneele durch den Abstand verhindert werden kann. Dennoch ist es mit der Bündelung der reflektierten Lichtstrahlen möglich diese auf bestimmte Bereiche der Gruppe von Paneelen zu richten und damit ein gezieltes Ausleuchten der Gruppe zu erreichen.

Gemäß einer Ausführungsform weist die Reflektorvorrichtung mindestens eine Sensoreinheit zur Überwachung der Lichteinstrahlung auf und die Sensoreinheit ist mit einer Steuereinheit zur Ausrichtung des mindestens einen Reflektors bezüglich der Solaranlage der Solareinrichtung verbunden. Damit kann die Lichtausbeute optimiert werden. Die Ausrichtung einzelner Reflektoren erfolgt hierbei vorzugsweise bezüglich einer Gruppe von Solarpaneelen. Die Sensoreinheit zur Überwachung der Lichteinstrahlung kann insbesondere die Intensität der Lichteinstrahlung überwachen. Diese Intensität kann entweder mit Sollwerten oder mit zuvor gemessenen Werten verglichen werden und bei einer Abweichung kann der mindestens eine Reflektor so angesteuert werden, dass dessen Ausrichtung so lange verändert wird, bis der Sollwert erreicht oder die Abweichung zu gemessenen Werten auf einem Minimum ist. Die Überwachung und Ausrichtung können durch die Sensoreinheit und die Steuereinheit an der Reflektorvorrichtung erfolgen. Die Steuereinheit dient hierbei vor allem zum Ansteuern einer Bewegungsvorrichtung zum Bewegen des Reflektors oder der Reflektoren. Weiterhin kann bei der Überwachung und Ansteuerung zur Ausrichtung des mindestens einen Reflektors auch der zu erwartende Sonnenstand berücksichtigt Hierdurch kann den unterschiedlichen Tages- und Jahreszeiten Rechnung getragen werden.

Erfindungsgemäß ist es auch möglich dass die Sensoreinheit an der Solaranlage vorgesehen ist. Eine solche Sensoreinheit kann beispielsweise die an den Absorbern oder Solarmodulen erhaltene Lichteinstrahlungen detektieren. Diese Detektionswerte können dann gegebenenfalls zur Anpassung der Ausrichtung des oder der Reflektoren der Reflektorvorrichtung, die diesen Solarpaneelen zugeordnet sind, verwendet werden.

Durch das Vorsehen einer Sensoreinheit und einer damit verbundenen Steuerungseinheit zur Ausrichtung der Reflektoren kann die Erhöhung der Wirksamkeit einer Solaranlage weiter verbessert werden, da die Ausrichtung den tatsächlichen Verhältnissen auf einfache Weise angepasst werden kann.

Der Reflektor oder die Reflektoren können aus verschiedenen Materialien hergestellt sein. Die Erfindung ist somit nicht auf ein bestimmtes Material des Reflektors oder der Reflektoren beschränkt. Gemäß einer Ausführungsform besteht der mindestens eine Reflektor aus Kunststoff und ist weiter vorzugsweise durch Spritzguss hergestellt. Durch die Ausgestaltung des oder der Reflektoren aus Kunststoff wird das Gewicht der einzelnen Reflektoren, insbesondere gegenüber Reflektoren, die aus Metall bestehen. Durch das geringere Gewicht, ist die Energiemenge, die zum Bewegen, das heißt zur Ausrichtung der Reflektoren notwendig ist, minimiert werden. Zudem kann die Größe der Reflektoren größer gewählt werden als bei Reflektoren aus schwerem Material. Dadurch kann auch die Reflexionsfläche vergrößert werden und die Menge an Lichtstrahlen, die reflektiert werden erhöht werden. Die Herstellung des Reflektors durch Spritzguss weist den Vorteil auf, dass auch komplexe Formen, wie beispielsweise Prismen an der Reflexionsfläche, auf einfache Weise und zuverlässig erzeugt werden können.

Vorzugsweise wird die erfindungsgemäße Reflektorvorrichtung in einer Solareinrichtung gemäß der vorliegenden Erfindung verwendet. Dies bedeutet, dass die Solareinrichtung mindestens eine erfindungsgemäße Reflektorvorrichtung aufweist.

Vorteile und Merkmale, die bezüglich der Solareinrichtung beschrieben werden gelten - soweit anwendbar - entsprechend für Reflektorvorrichtung und umgekehrt.

Die Erfindung wird im Folgenden erneut unter Bezugnahme auf die beiliegenden Zeichnungen genauer erläutert. Es zeigen:
Figur 1: eine schematische Darstellung einer Ausführungsform der erfindungsgemäßen Solareinrichtung; und
Figur 2: eine schematische Darstellung einer Ausführungsform einer erfindungsgemäßen Reflektorvorrichtung.

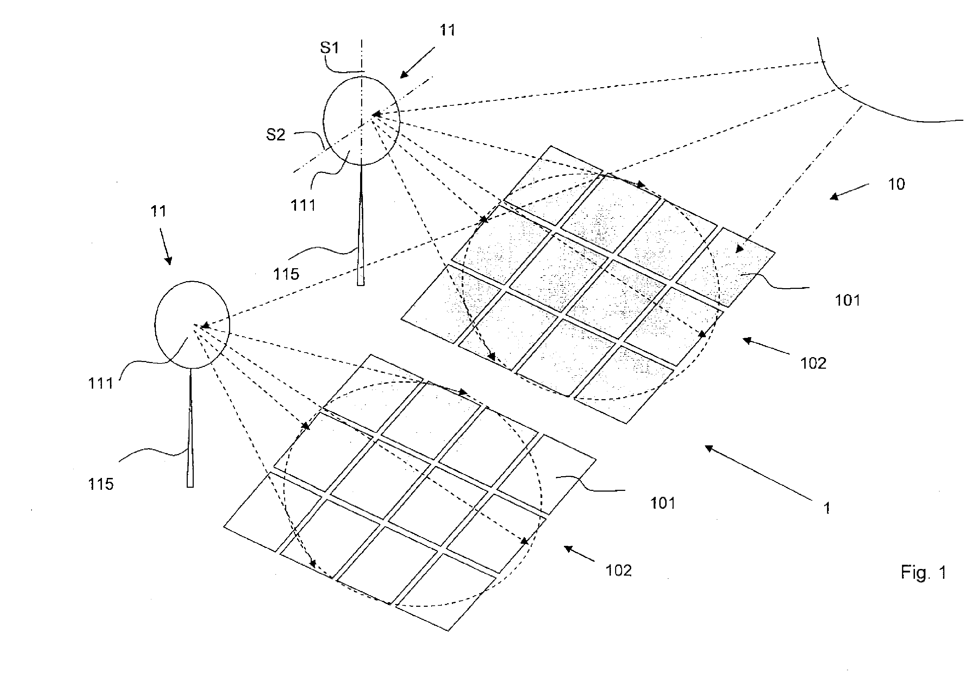

In Figur 1 ist eine Ausführungsform einer erfindungsgemäßen Solareinrichtung 1 gezeigt. Die Solareinrichtung 1 umfasst in der dargestellten Ausführungsform zwei Reflektorvorrichtungen 11 und eine Solaranlage 10. Die Solaranlage 10 besteht aus zwei Gruppen 102 von Paneelen 101, die auch als Felder bezeichnet werden. Jede Gruppe 102 besteht aus zwölf Paneelen 101. Es versteht sich aber, dass die Anzahl der Paneele 101 pro Gruppe 102 auch größer sein kann. Jeder Gruppe 102 ist eine Reflektorvorrichtung 11 zugeordnet. Die Reflektorvorrichtungen 11 sind jeweils zu der ihr zugeordneten Gruppe 102 beabstandet angeordnet. Die Reflektorvorrichtungen 11 bestehen aus einem Reflektor 111, der an einer Haltevorrichtung 115 befestigt ist. In der dargestellten Ausführungsform stellt die Haltevorrichtung 115 einen Mast oder Pfosten dar und der Reflektor 111 ist an dem oberen Ende der Haltevorrichtung 115 befestigt. Die Reflektorvorrichtung 11 ist daher seitlich zu der zugeordneten Gruppe 102 beabstandet. Zudem ist der Reflektor 11 nach oben zu der zugeordneten Gruppe 102 beabstandet.

Der Reflektor 111 ist so ausgerichtet, dass Sonnenstahlen, die auf diesen auftreffen, auf die Gruppe 102 von Paneelen 101 reflektiert werden, der die Reflektorvorrichtung 11 zugeordnet ist. Die Reflektoren 111 weisen in der dargestellten Ausführungsform eine streuende Reflexionsfläche auf. Die auf den Reflektor 111 auftreffenden Strahlen werden somit gestreut von dem Reflektor 11 wieder abgegeben und auf die Gruppe 102 verteilt. Da die Reflektorvorrichtung 11 zudem in einem Abstand zu der Gruppe 102 angeordnet ist, der diese zugeordnet ist, kann auch bei einer im Vergleich zu der Größe der Fläche der Gruppe 102 kleinen Reflexionsfläche die Gruppe 102 weitestgehend von dem Reflektor 111 ausgeleuchtet werden. Da zudem, wie durch die strichpunktierte Linie in Figur 1 angedeutet, außer den reflektierten Lichtstrahlen auch unmittelbare Lichtstrahlen auf die Paneele 101 der Gruppe 102 auftreffen, werden die an den einzelnen Paneelen 101 zur Umwandlung zur Verfügung gestellten Lichtstrahlen maximiert.

Die Reflektoren 111 sind an der Haltevorrichtung 115 schwenkbar angebracht. Wandert die Sonne, so kann der Reflektor 111 um eine Schwenkachse S1, die der Längsachse der Haltevorrichtung 115 entspricht, verschwenkt werden. Dadurch wird auch zu unterschiedlichen Tageszeiten gewährleistet, dass die Sonnenstrahlen, die auf den Reflektor 111 auftreffen, so reflektiert werden, dass diese auf die Gruppe 102, die der Reflektorvorrichtung 11 zugeordnet ist, ausgerichtet bleibt. Zusätzlich kann der Reflektor 111 um eine Schwenkachse S2 verschwenkt werden, die senkrecht zu der Längsachse der Haltevorrichtung 115 steht und in Projektion auf die Fläche des Reflektors 111 in der Fläche des Reflektors 111 liegt. Durch Verschwenken des Reflektors 111 um diese Achse S2, wird der Reflektor 111 weiter nach oben oder nach unten geneigt. Dieses Verschwenken des Reflektors 111 kann somit unterschiedlichen Sonnenständen, die beispielsweise aufgrund der Tageszeit und der Jahreszeit bestehen, Rechnung tragen.

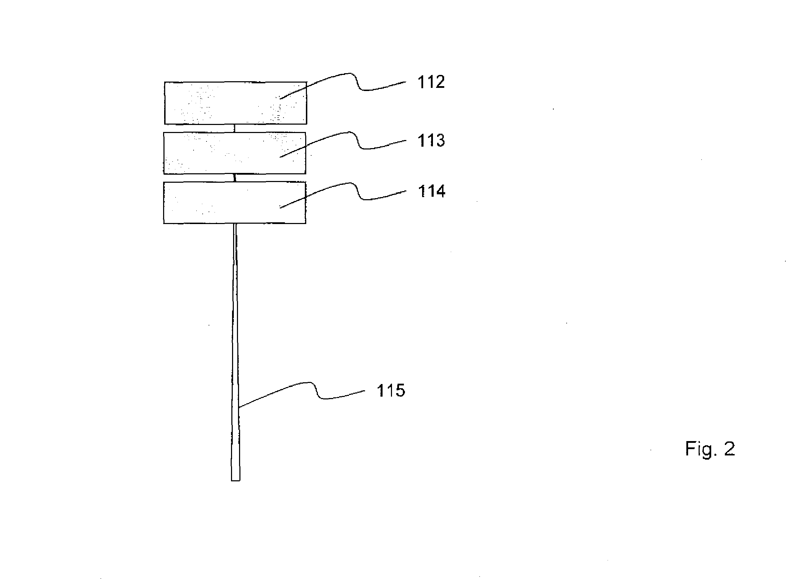

In Figur 2 ist eine weitere Ausführungsform einer erfindungsgemäßen Reflektorvorrichtung 11 gezeigt. Bei dieser Ausführungsform sind an einer Haltevorrichtung 115, die ebenfalls als Mast oder Pfosten ausgestaltet ist, drei Reflektoren 112, 113, 114 vorgesehen. Jeder dieser Reflektoren 112, 113, 114 kann unabhängig von dem jeweils anderen Reflektor 112, 113, 114 relativ zu der Haltevorrichtung 115 bewegt werden. Durch eine solche Reflektorvorrichtung 11 können entweder unterschiedliche Paneele 101 einer Gruppe 102 mit reflektierten Lichtstrahlen versorgt werden oder die einzelnen Reflektoren 112, 113, 114 können jeweils unterschiedliche Gruppen 102 mit reflektierten Lichtstrahlen versorgen.

Die vorliegende Erfindung ist nicht auf die dargestellten Ausführungsformen beschränkt. Insbesondere können die Anzahl der Paneele in einer Gruppe, die Anzahl der Gruppen, die Anzahl der Reflektorvorrichtungen und die Zuordnung von Reflektorvorrichtungen zu Gruppen von den in den Figuren Gezeigten abweichen.

Alternativ oder zusätzlich zu den gezeigten Ausführungsformen kann die Reflektorvorrichtung auch in einer anderen Himmelsrichtung bezüglich der Gruppe von Paneelen angeordnet sein. Beispielsweise kann eine Reflektorvorrichtung westlich und eine Reflektorvorrichtung östlich von der Gruppe angeordnet sein.

Weiterhin kann der oder können die Reflektoren auch so an der Haltevorrichtung befestigt sein, dass diese vertikal, insbesondere entlang der Längsachse der Haltevorrichtung, verschoben werden können. Zudem kann auch die Haltevorrichtung als solche beweglich vorgesehen sein, um die Position der Haltevorrichtung relativ zu der Gruppe der Paneele ändern zu können.

Schließlich kann an der Reflektorvorrichtung auch eine Bewegungsvorrichtung zum Bewegen des oder der Reflektoren vorgesehen sein. Diese kann elektrisch, pneumatisch, mechanisch und/oder hydraulisch ausgeführt sein. Die Bewegungsvorrichtung ist mit einer Steuereinheit verbunden und wird von dieser angesteuert. Die Steuereinheit wiederum kann mit einer Sensoreinheit verbunden sein. In der Sensoreinheit kann die Intensität der auftreffenden Lichtstrahlen gemessen werden. Diese Information kann dann in der Steuereinheit oder einer separaten Verarbeitungseinheit mit weiteren Daten, wie Tageszeit, Jahreszeit und hinterlegten Vergleichsdaten verarbeitet werden, um die geeignete Position und Ausrichtung des oder der Reflektoren bestimmen zu können.

### Bezugszeichenliste

- 1: Solareinrichtung
- 10: Solaranlage
- 101: Paneel
- 102: Gruppe von Paneelen
- 11: Reflektorvorrichtung
- 111: Reflektor
- 112: Reflektor
- 113: Reflektor
- 114: Reflektor
- 115: Haltevorrichtung
- S1: Schwenkachse
- S2: Schwenkachse

## Patentansprüche

1. Solareinrichtung, die mindestens eine Solaranlage (10) mit mindestens einer Gruppe von Solarpaneelen (101) und mindestens eine Reflektorvorrichtung (11) aufweist, **dadurch gekennzeichnet, dass** die mindestens eine Reflektorvorrichtung (11) zu der mindestens einen Gruppe (102) der Solarpaneele (101) beabstandet angeordnet ist und bezüglich dieser Gruppe (102) der Solarpaneele (101) ausrichtbar ist.

2. Solareinrichtung nach Anspruch 1, **dadurch gekennzeichnet, dass** die mindestens eine Reflektorvorrichtung (11) im montierten Zustand westlich, nördlich oder östlich zu der Solaranlage (10) angeordnet ist.

3. Solareinrichtung nach einem der Ansprüche 1 oder 2, **dadurch gekennzeichnet, dass** die mindestens eine Reflektorvorrichtung (11) solche Abmessungen aufweist und so angeordnet ist, dass die von der Reflektorvorrichtung (11) auf die Solaranlage (10) reflektierten Lichtstrahlen zumindest auf zwei Solarpaneele (101) der Solaranlage (10) auftreffen.

4. Reflektorvorrichtung (11) für eine Solareinrichtung (1) mit mindestens einer Solaranlage (10) mit mindestens zwei Solarpaneelen (101), wobei die Reflektorvorrichtung (11) eine Haltevorrichtung (115) und mindestens einen Reflektor (111, 112, 113, 114) umfasst, **dadurch gekennzeichnet, dass** der mindestens eine Reflektor (111, 112, 113, 114) an der Haltevorrichtung (115) schwenkbar befestigt ist.

5. Reflektorvorrichtung nach Anspruch 4, **dadurch gekennzeichnet, dass** diese mindestens zwei Reflektoren (111, 112, 113, 114) aufweist und die mindestens zwei Reflektoren (111, 112, 113, 114) unabhängig voneinander bewegt werden können.

6. Reflektorvorrichtung nach einem der Ansprüche 4 oder 5, **dadurch gekennzeichnet, dass** mindestens einer der Reflektoren (111, 112, 113, 114) eine streuende oder eine bündelnde Reflexionsfläche aufweist.

7. Reflektorvorrichtung nach einem der Ansprüche 4 bis 6, **dadurch gekennzeichnet, dass** die Reflektorvorrichtung (11) mindestens eine Sensoreinheit zur Überwachung der Lichteinstrahlung aufweist und die Sensoreinheit mit einer Steuereinheit zur Ausrichtung des mindestens einen Reflektors (111, 112, 113, 114) bezüglich der Solaranlage (10) der Solareinrichtung (1) verbunden ist.

8. Reflektorvorrichtung nach einem der Ansprüche 4 bis 7, **dadurch gekennzeichnet, dass** der mindestens eine Reflektor (111, 112, 113, 114) aus Kunststoff besteht und vorzugsweise durch Spritzguss hergestellt ist.

9. Reflektorvorrichtung nach einem der Ansprüche 4 bis 8, **dadurch gekennzeichnet, dass** der mindestens eine Reflektor (111, 112, 113, 114) eine konvexe oder eine konkave Reflexionsfläche aufweist.

10. Solareinrichtung nach einem der Ansprüche 1 bis 3, **dadurch gekennzeichnet, dass** diese mindestens eine Reflektorvorrichtung (11) nach einem der Ansprüche 4 bis 9 aufweist.
